# FASCICULE DE BREVET EUROPEEN

(11) **EP 2 794 463 B1**
(45) Date de publication et mention de la délivrance du brevet: **15.03.2017**
(21) Numéro de dépôt: 12821019.2
(22) Date de dépôt: 21.12.2012
(51) Int. Cl.: B81C 99/00, B81B 3/00

(54) **METHODE DE LIBERATION D'UNE PIECE MICROMECANIQUE ET PIECE MICROMECANIQUE COMPRENANT DES ATTACHES SACRIFICIELLES**
VERFAHREN ZUR FREISETZUNG EINES MIKROMECHANISCHEN BAUTEILS MIT ZERBRECHLICHEN BEFESTIGUNGSELEMENTEN
METHOD FOR FREEING A MICROMECHANICAL PART AND A MICROMECHANICAL PART COMPRISING SACRIFICIAL FASTENERS

(30) Priorité: 22.12.2011 CH 20332011
(43) Date de publication de la demande: 29.10.2014
(73) Titulaire: CSEM Centre Suisse d'Electronique et de Microtechnique SA - Recherche et Développement, 2002 Neuchâtel (CH)
(72) Inventeur: BARROT, François, CH-3235 Erlach (CH); FOURNIER, Rémy, F-25130 Villers-le-Lac (FR); GIRIENS, Laurent, CH-1012 Lausanne (CH); HENEIN, Simon, CH-2000 Neuchâtel (CH); JEANNERET, Sylvain, CH-2013 Colombier (CH); KRUIS, Johan, CH-2000 Neuchâtel (CH)
(74) Mandataire: Gevers SA
(86) Numéro de dépôt international: PCT/EP2012/076860
(87) Numéro de publication internationale: WO 2013/093108

(56) Documents cités:
- CH-A1- 699 110
- US-A1- 2008 116 533
- US-A1- 2010 306 993

## Description

### Domaine technique

La présente invention se rapporte au domaine de la micromécanique. Elle concerne plus particulièrement une méthode de fabrication d'une pièce micromécanique. Elle trouve une application particulière dans le domaine de l'usinage de pièces par gravure profonde, notamment de pièces fragiles, en silicium, en verre ou en alliages métalliques. Elle s'applique également à d'autres processus d'usinage tel que : usinage laser, usinage jet d'eau, usinage par électroérosion, usinage LIGA, usinage chimique du verre, etc.

L'invention concerne également une pièce susceptible d'être obtenue par cette méthode.

### Etat de la technique

Actuellement, comme représenté sur la figure 0 et divulgué par exemple dans la demande CH 699 110 A1, lors d'usinage d'une pièce b à partir d'un substrat c de type wafer, la pièce est réalisée en conservant des petits ponts a de matière qui relient la pièce b au substrat c. Ces ponts a forment des points faibles qui sont ensuite cassés avec un outil d qui les sollicite en flexion ou en cisaillement. Cette méthode induit des contraintes importantes dans la pièce au moment de la casse des ponts. De plus, l'énergie requise pour casser les ponts est importante et sa libération subite au moment de la rupture provoque parfois des dégâts sur les zones fragiles de la pièce, parfois même à une distance importante du pont lui-même (transmission de l'onde de choc à travers la pièce ou le wafer). Or, certaines pièces réalisées comportent parfois des pivots flexibles qui sont aussi faibles que les ponts et qui peuvent être cassés par l'énergie libérée lors de la rupture des ponts.

Pour éviter ces problèmes, on a parfois recours à une libération des pièces par découpe laser des ponts. Cette démarche est complexe et coûteuse et laisse des moignons de ponts dont l'aspect est généralement peu apprécié.

Par ailleurs, les déformations subies par le substrat ou la pièce en cours de fabrication ou d'assemblage, génèrent aussi des contraintes sur la pièce qui induisent parfois des dégâts ou des ruptures.

La présente invention vise à résoudre ces problèmes de manière simple, efficace et économique.

### Divulguation de l'invention

De façon plus précise, l'invention concerne une méthode de fabrication d'une pièce micromécanique à partir d'un substrat dans laquelle la pièce est fabriquée en ménageant une pluralité d'attaches entre la pièce et le substrat, lesdites attaches étant sacrificielles. Les attaches comprennent au moins une articulation à l'extrémité de chaque attache située du côté de la pièce. La méthode comprend une étape de rupture des attaches sacrificielles.

L'invention porte également sur une pièce comprenant un bâti et une portion articulée en référence au bâti, au moins un guidage entre la portion et le bâti selon au moins un degré de liberté et au moins une liaison sacrificielle entre la portion articulée et le bâti en la forme d'un verrou de libération susceptible d'occuper deux états, un état singulier qui permet de bloquer au moins un degré de liberté de la portion articulée et un deuxième état qui permet de mettre ladite portion en mouvement selon ledit degré de liberté du guidage bloqué dans l'état singulier, jusqu'à la rupture de la liaison sacrificielle, le mouvement induit par le déverrouillage étant toléré par le guidage.

### Brève description des dessins

D'autres détails de l'invention apparaîtront plus clairement à la lecture de la description qui suit, faite en référence au dessin annexé dans lequel :
- la figure 0, déjà mentionnée, se rapporte à l'état de la technique,
- les figures 1 à 17 proposent différentes illustrations de types d'attache pouvant être utilisés pour relier une pièce à son wafer,

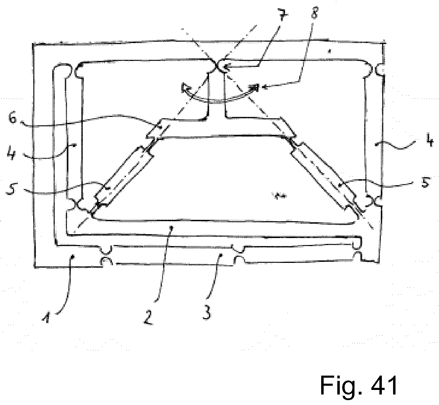

- les figures 18 à 41 représentent des exemples d'applications de l'invention.

### Mode de réalisation de l'invention

L'un des principes de base de l'invention est de relier une pièce usinée dans un substrat par des attaches sacrificielles qui, de manière particulièrement avantageuse, comprennent au moins une articulation à l'une de leur extrémité située entre l'attache et la pièce. On peut avantageusement prévoir une deuxième articulation à l'extrémité située entre l'attache et le substrat. En combinant de manière adaptée les différents types de liaison qui vont être décrits ci-après, on peut contrôler les degrés de liberté de la pièce par rapport au substrat et, ainsi, autoriser les mouvements de la pièce dans certaines directions, afin de limiter les contraintes subies par la pièce, tout en la maintenant rigidement dans d'autres directions.

### Profils des cols

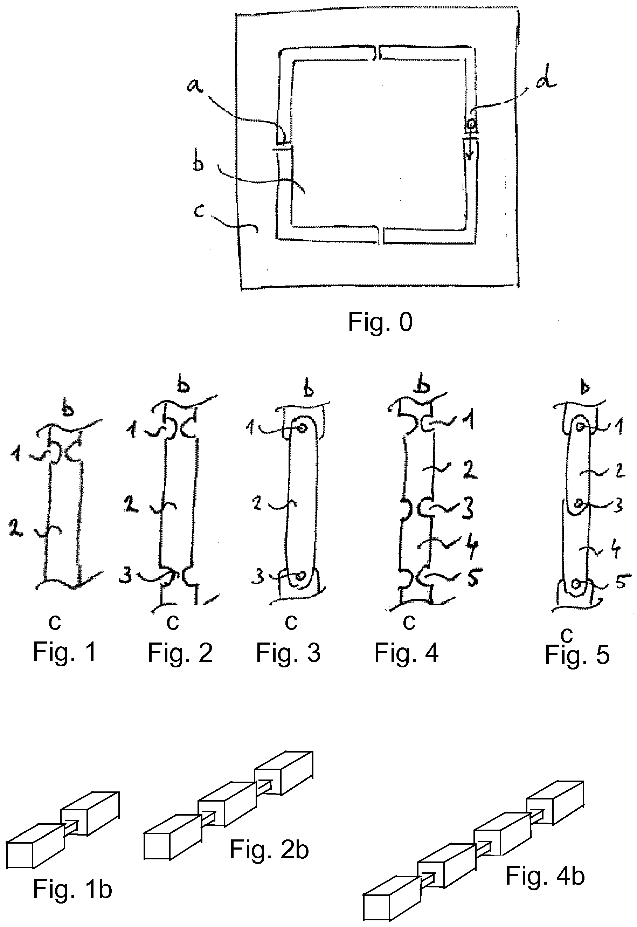

Les articulations des attaches sont réalisées par des amincissements ménagés dans des poutres ou dans des lames qui forment les attaches. Typiquement, l'amincissement est environ 10 fois plus faible que l'attache. Il présente une dimension sectionnelle environ 10 fois inférieure à celle de l'attache, et une dimension longitudinale inférieure à 1/10ème de la longueur de l'attache. Si l'amincissement ne concerne qu'une dimension de la section de la poutre, le col est dit 2D (fig. 1), car il peut être fabriqué par un processus d'usinage bidimensionnel. Si l'amincissement concerne les deux dimensions de la section de la poutre, le col est dit 3D (fig. 1b), car il requiert un usinage en trois dimensions.

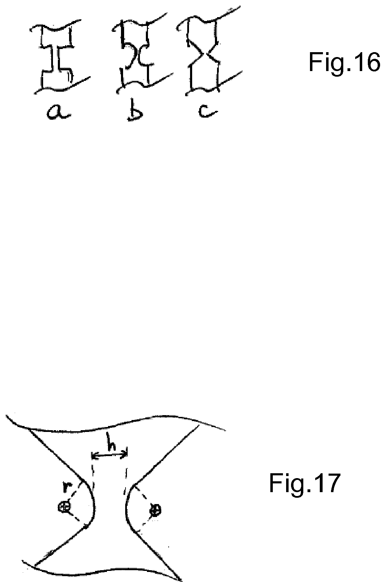

Différents profils de cols peuvent être utilisés (fig. 16) pour former les articulations. Les plus courants sont le col prismatique (a), le col circulaire (b) et le col à entaille (c). On a représenté ici des cols 2D, mais ces représentations peuvent être transposées à des cols 3D. Le col à entaille représenté de manière agrandie sur la figure 17 est particulièrement adapté à la présente invention, car il permet de concentrer les contraintes dans un volume de matière très réduit lorsque le col est sollicité en flexion simple. Ainsi, si on souhaite obtenir une rupture, celle-ci se produit avec une libération d'énergie élastique réduite. L'effet de concentration de contrainte peut être accentué en réduisant le rayon *r* en fond d'entaille pour le rendre sensiblement inférieur à l'épaisseur *h* du pont résiduel.

### Les différents types de liaisons

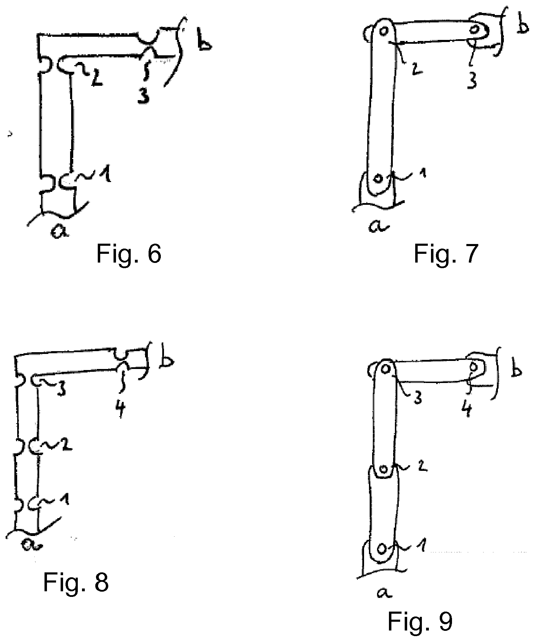

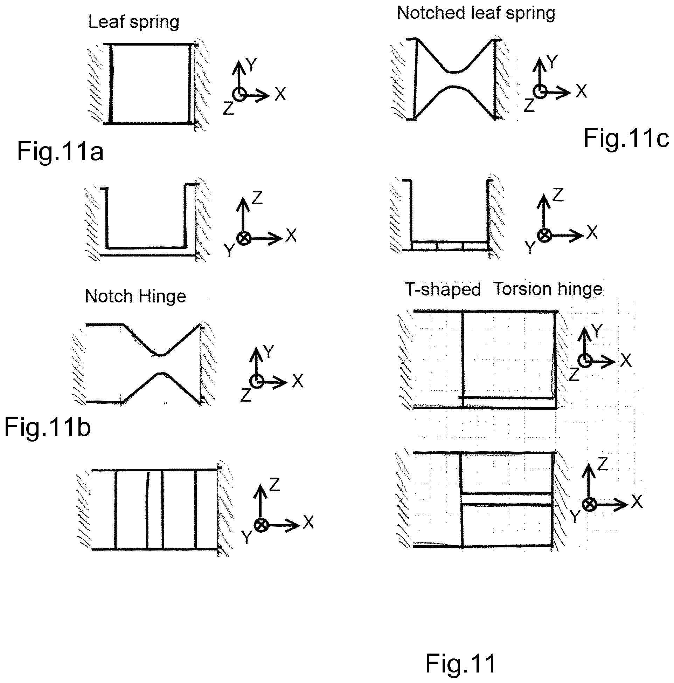

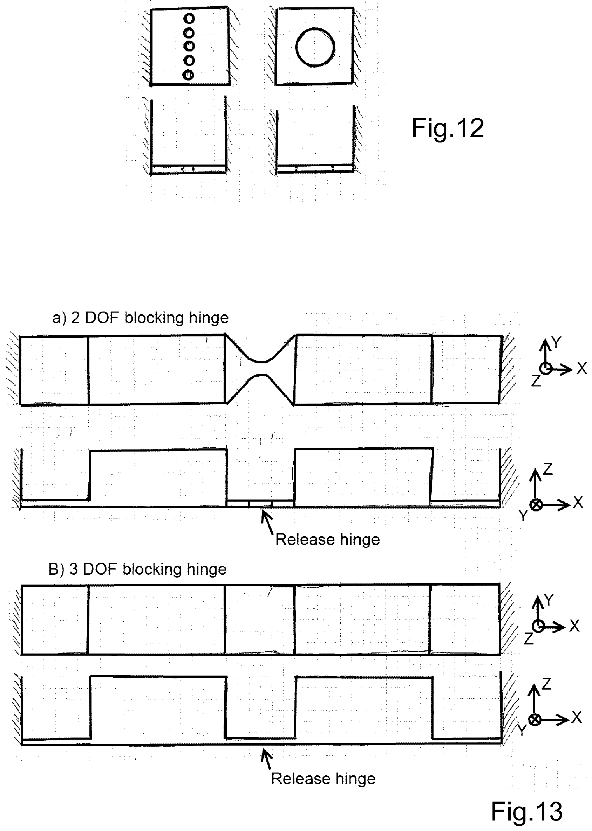

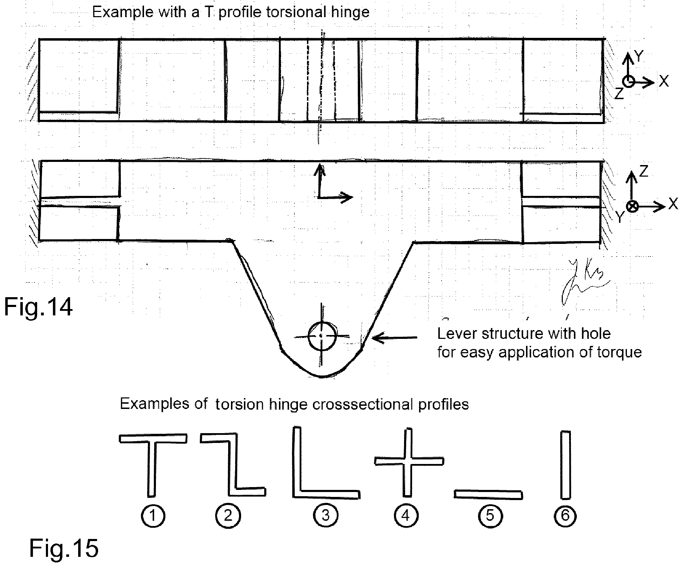

Onze chaînes de liaisons différentes peuvent être utilisées dans le cadre de cette invention.
1. La « biellette simple » (fig. 2) est constituée de deux cols flexibles (1) et (3) et d'un segment rigide (2). Dans une analyse planaire, sa fonction cinématique est identique à une biellette simple articulée par deux pivots (fig. 3).
2. La « biellette à genouillère » (fig. 4) est identique à la biellette simple, mais comporte en outre un troisième col flexible (3) situé approximativement au milieu du segment rigide. Dans une analyse planaire, sa fonction cinématique est identique à une genouillère simple (fig. 5).
3. Le « L simple » (fig. 6) est constitué de trois cols flexibles (1, 2 et 3) connectant deux segments rigides approximativement perpendiculaires. Dans une analyse planaire, sa fonction cinématique est identique à la chaîne (fig. 7).
4. Le « L à genouillère » (fig. 8) est identique au L simple, mais comporte en outre un col supplémentaire (2) formant une genouillère. Dans une analyse planaire, sa fonction cinématique est identique à une chaîne (fig. 9).
5. On peut également utiliser des liaisons de type biellette de l'espace (fig. 2b), c'est-à-dire une biellette dotée d'une rotule à chacune de ses extrémités, qui libère la pièce dans tous ses degrés de liberté, sauf la traction-compression.
6. La biellette de l'espace à genouillère comporte, comme la biellette de l'espace, une rotule à chacune de ses extrémités. Elle comporte également une genouillère, qui peut être une genouillère de l'espace (fig. 4b), définie par un col 3D, c'est-à-dire mobile dans les trois dimensions, ou une genouillère planaire (non représentée), définie par un col 2D, c'est-à-dire mobile dans deux dimensions.

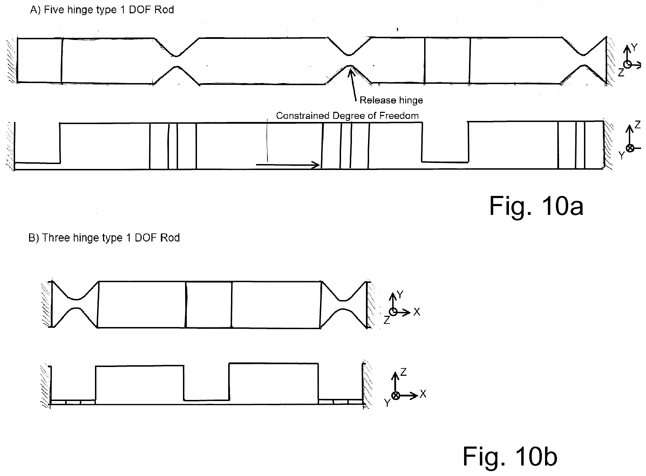

   Les figures 10a et 10b illustrent deux variantes de biellettes de l'espace à genouillère. Dans la figure 10a, les rotules sont définies par la combinaison de deux cols 2D croisés, c'est-à-dire orientés de manière orthogonale. Entre les deux rotules, un col 2D forme la genouillère. Dans la figure 10b, on a une biellette de l'espace équivalente, dans laquelle les rotules sont réalisées par des cols 3D et que la genouillère est représentée selon une orientation différente. Dans les deux cas, on obtient une biellette de l'espace ne contraignant qu'un degré de liberté, celui de la traction-compression.
   On notera que les cols peuvent être adaptés en créant, comme le montre la figure 12, des zones de fragilité permettant de concentrer les contraintes de manière précise et, le cas échéant, d'obtenir des ruptures de ces cols, dans des endroits clairement déterminés, comme on le comprendra par la suite. Ces zones de fragilité peuvent être obtenues en ménageant une ou plusieurs ouvertures alignées dans les zones de flexion.
7. Comme septième type de chaine de liaison, la figure 14 propose un barreau de torsion comportant une articulation en torsion combinant au moins deux structures souples en torsion. On peut obtenir ce genre de structure par des zones présentant un profil de torsion particulier, comme illustré sur la figure 15 (ref. 1-4), toute présentant des sections à parois minces non fermées, donc partiellement souple en torsion. On peut ainsi avoir des profils en T, en Z, en L, en croix qui permettent d'obtenir des articulations bloquant 5 degrés de liberté (seule la torsion est libre). Un profil en V fonctionne de cette manière aussi.
   On peut également avoir des barreaux de torsion mettant en oeuvre des biellettes simples (ref. 5, 6), horizontale ou verticale, qui bloquent 3 degrés de liberté. On peut mettre en série deux de ces biellettes pour, en fonction de leur agencement respectif, obtenir des articulations bloquant 3, 4 ou 5 degrés de liberté. Ainsi, on peut, par exemple, mettre en oeuvre deux biellettes simples agencées perpendiculairement l'une par rapport à l'autre, de manière à former un L, un T ou un V.
   Ce genre d'attache est particulièrement adapté pour les applications dans lesquelles on ne dispose que de peu de surface sur le substrat pour lesquelles une rupture de l'attache par torsion est idéale. On peut également disposer deux biellettes en série, dont les axes sont coïncidents. Cela permet d'obtenir une articulation bloquant 3 degrés de liberté. En combinant ces deux variantes, on obtient une articulation bloquant 4 degrés de liberté.
   La pièce peut être dotée d'une portion d'actuation, excentrée par rapport à l'axe de l'articulation et permettant de la solliciter plus aisément en torsion. Cette portion peut être une poutre, dotée d'un trou avec lequel peut coopérer un outil.
8 et 9. On peut également relier la pièce au substrat directement par un col 2D (fig. 11a et 11b) ou par un col 3D (fig. 11 c), tels que définis ci-dessus.
10. On peut réaliser une lame 2D à 3cols telle que proposée sur la figure 13b, qui permet de bloquer ou de libérer des degrés de liberté hors du plan. Dans cet exemple, on a trois cols 2D, ce qui permet d'obtenir une articulation bloquant trois degrés de liberté, à l'instar d'une lame simple.
11. On peut également réaliser une lame 3D à 3cols telle que proposée sur la figure 13a. Dans cet exemple, on a deux cols 2D et un col 3D, positionné entre les deux cols 2D. On obtient ainsi une attache bloquant deux degrés de liberté, à l'instar d'une lame simple dotée d'une entaille en son milieu.

Les attaches de type 10 et 11 peuvent comporter des moyens pour pousser la zone articulée centrale selon l'axe Z, jusqu'à obtenir sa rupture, notamment pour des applications décrites ultérieurement. Des zones de fragilité telles que proposées sur la figure 12 peuvent aussi être ajoutées dans le col central de l'attache.

Ainsi, en disposant des attaches choisies parmi les différentes liaisons possibles proposées ci-dessus, l'homme du métier peut libérer ou contraindre tel ou tel degré de liberté, en fonction de la mobilité que l'on souhaite donner à la pièce en référence à son substrat, lors de sa fabrication et par rapport à son application. La pièce peut être bloquée rigidement sur le substrat ou on peut, par exemple, libérer la flexion dans l'une ou l'autre direction.

### Représentation simplifiée

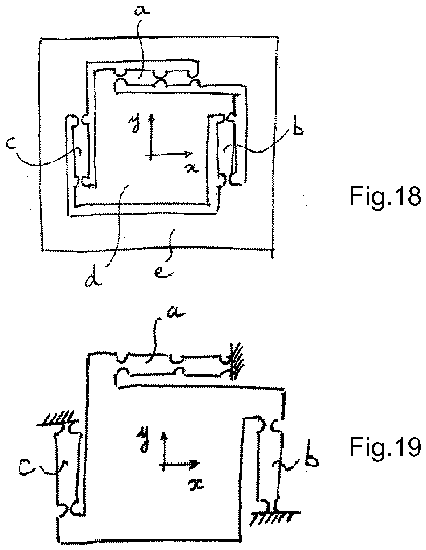

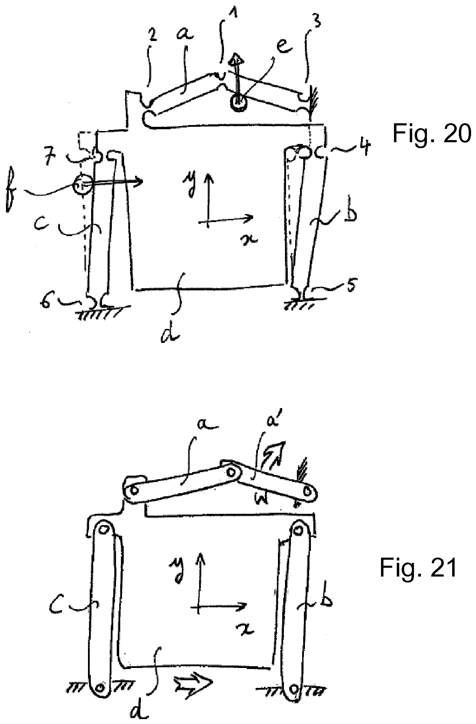

Par souci de simplicité, les figures 20 à 37 utilisent une représentation conventionnelle. A titre d'exemple, la structure de la figure 18 est représentée de manière simplifiée sur la figure 19 : le substrat est symbolisé par des liaisons de terre (hachures a, b et c) à la base des cols.

### Principe de la liaison de base

Comme on va le détailler ci-après, un premier aspect de l'invention réside dans l'utilisation des liaisons décrites ci-dessus pour relier une pièce au substrat dans lequel elle a été usinée. Les liaisons formées entre la pièce et son substrat doivent être brisées de manière à libérer la pièce pour permettre son utilisation. Ainsi, les liaisons sont utilisées de manière sacrificielle. De manière avantageuse, les liaisons sont mises en oeuvre afin maitriser l'énergie produite lors de la libération de la pièce et éviter ou du moins limiter les risques de casse de la pièce.

La figure 20 montre un exemple typique de liaison par biellette entre une pièce (d) et un wafer (e) dans lequel la pièce a été usinée. La pièce (d) est attachée de manière rigide à son wafer (e) par deux biellettes simples (b) et (c) et une biellette à genouillère (a). Dans cet arrangement, à elles seules, les deux biellettes simples confèrent à la pièce un unique degré de liberté qui correspond à une translation le long de l'axe x (pour des mouvements d'amplitude infinitésimale). La biellette à genouillère vient, quant à elle, bloquer cet unique degré de liberté, ce qui supprime la possibilité de tout mouvement relatif de la pièce par rapport au wafer.

Pour procéder à la libération de la pièce (fig. 20), un outil (e) est utilisé pour fléchir la genouillère selon son degré de liberté naturel jusqu'à rupture des trois cols (1, 2 et 3). Lors de la flexion de la genouillère, un mouvement du second ordre (raccourcissement de la biellette) induit un mouvement de translation de la pièce le long de l'axe *x*(d). Ce degré de liberté étant naturel pour les biellettes simples (b) et (c), il n'induit pas de forces ni de contraintes importantes dans la pièce elle-même. Ce phénomène cinématique est également illustré sur la figure 21.

Une fois que la biellette à genouillère a été retirée, un outil (f) (fig. 20) est utilisé pour fléchir l'une des deux biellettes simples selon son mouvement naturel jusqu'à rupture de ses cols (il est également possible d'agir directement sur la pièce avec l'outil et de la déplacer selon son degré de liberté naturel). Enfin les cols de la dernière biellette peuvent être rompus (s'ils n'ont pas été rompus en même temps que ceux de la seconde). La rupture induite par le déplacement selon le degré de liberté naturel se produit sans dissipation excessive d'énergie dans la pièce.

### Conditions cinématiques de bon fonctionnement

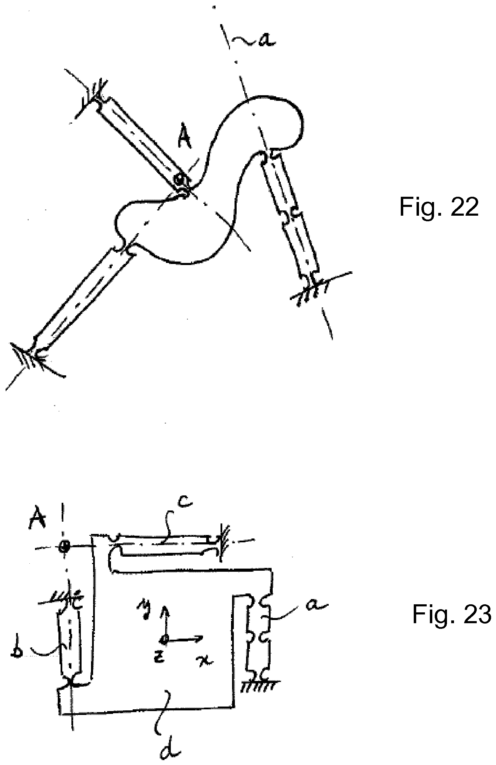

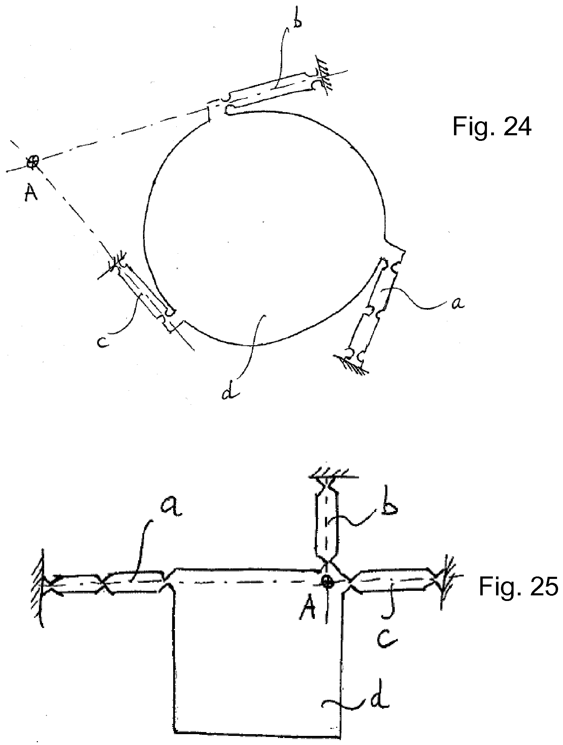

Pour que le principe de liaison fonctionne (fig. 22), il suffit que l'axe (a) de la biellette à genouillère ne passe pas par le point de concours (A) des deux axes des deux autres biellettes. Les figures 23 et 24 montrent deux exemples typiques.

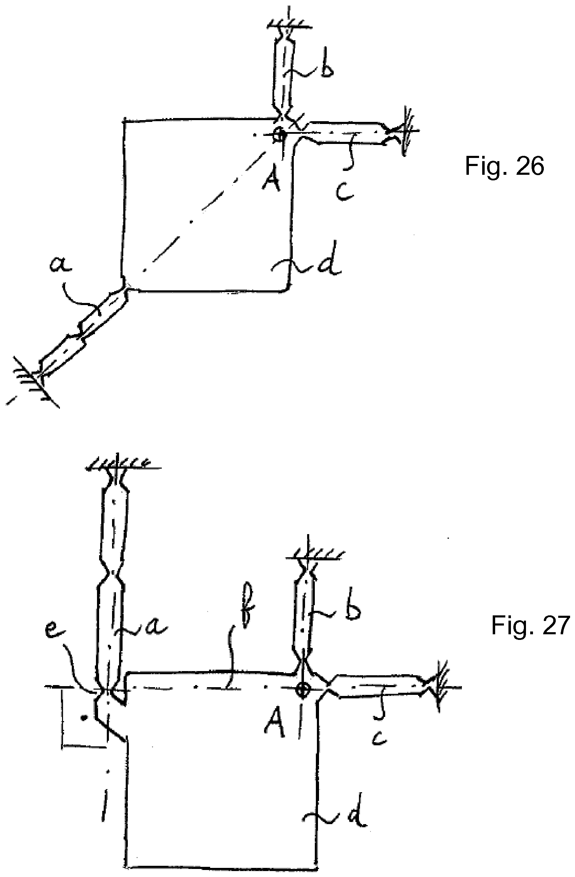

A titre d'exemple, les figures 25 et 26 proposent deux arrangements qui ne respectent pas cette condition et qui conduisent à deux problèmes.
- La liaison de la pièce au wafer n'est pas rigide, car pour des mouvements de faible amplitude, un degré de liberté subsiste : il s'agit du pivotement de la pièce autour du point de concours (A) entre les trois axes des trois biellettes.
- Lors de l'opération de libération, la flexion de la biellette à genouillère produit un déplacement du deuxième ordre (raccourcissement de la biellette) qui est bloqué par les deux autres biellettes. Ceci provoque le transit de forces importantes à travers la pièce elle-même (et par réaction au travers du wafer). Ainsi des risques de rupture de la pièce ou du wafer surviennent.

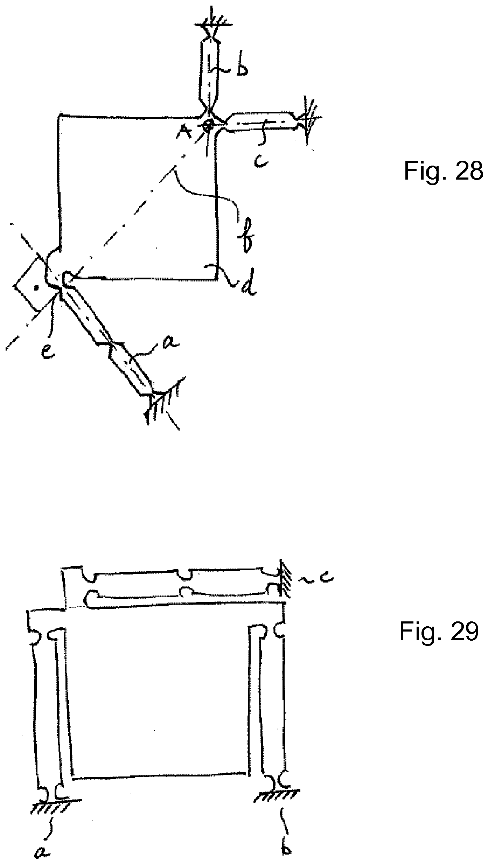

Les arrangements qui produisent la plus haute rigidité dans le plan, dont les figures 27 et 28 proposent deux exemples avantageux, sont ceux où l'axe (a) de la biellette à genouillère est perpendiculaire à la ligne (f) connectant le point de concours (A) des axes des deux biellettes simples au premier col (e) de la biellette à genouillère.

Dans les cas où les deux biellettes simples sont parallèles, les arrangements qui produisent la plus haute rigidité dans le plan sont ceux où la biellette à genouillère est perpendiculaire aux deux autres biellettes. Les figures 19 et 29 en montrent deux exemples.

### Analyse cinématique

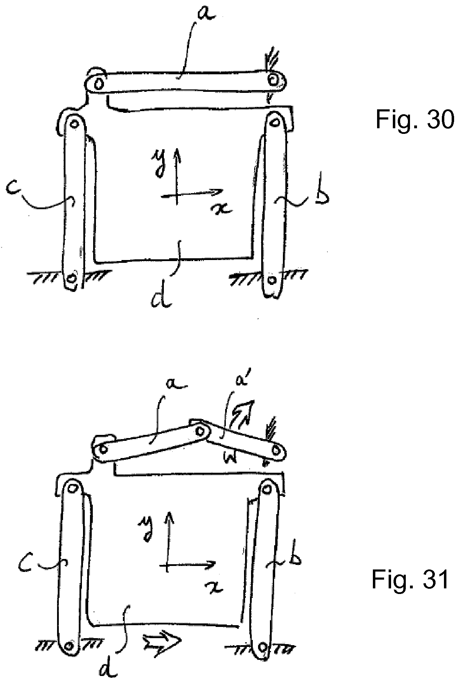

Dans une analyse cinématique planaire, le principe de liaison se base sur la structure de la figure 30. Cette structure cinématique comporte 6 pivots et 2 boucles cinématiques fermées. Selon la méthode de calcul de la mobilité de Grübler, ceci correspond à une liaison à mobilité nulle 6-2x3=0. Ceci correspond à une liaison bloquée, isostatique. Ainsi, cette liaison présente la propriété intéressante que de faibles variations dimensionnelles de la pièce, des biellettes ou du wafer (sous l'effet de dilatation thermique ou de contraintes internes ou externes par exemple) n'induisent pas de forces ni de contraintes élevées dans la pièce, réduisant les risques de casse inopinée.

L'introduction d'un col destiné à former un verrou de libération sur l'une des biellettes (fig. 31) ajoute une mobilité à la structure : 7-2x3=1. Par verrou de libération, on définit une attache qui peut occuper un état singulier dans lequel un degré de liberté est bloqué qui résulte en un verrouillage de la pièce et un deuxième état dans lequel ce degré de liberté est débloqué, ce qui permet de redonner un mouvement à la pièce, c'est-à-dire de la déverrouiller. Une excitation selon ce degré de liberté va permettre une rupture des différentes attaches.. Ainsi, dans sa configuration générique, cet arrangement cinématique ne constitue pas une liaison bloquée entre la pièce et le wafer. Néanmoins, il se trouve que la configuration particulière utilisée dans le cadre de la présente invention est une configuration singulière de cette structure cinématique où les 3 cols de la genouillère sont alignés. Dans une telle configuration, une genouillère est équivalente à une biellette simple. Ainsi, cette singularité de la cinématique fait disparaitre le degré de mobilité de la genouillère et la liaison entre la pièce et le wafer se comporte de la même manière que l'arrangement de la figure 30 : la pièce est rigidement attachée au substrat.

Dans son implémentation physique (par exemple une découpe monolithique dans un wafer), la stabilité de la genouillère autour de sa singularité d'alignement est garantie par les couples de rappel élastique des trois cols qui la constitue. En effet, ces trois cols sont usinés dans leur état neutre (c'est-à-dire sans sollicitation élastique) selon la disposition alignée. Le minimum d'énergie élastique correspond donc à la configuration d'alignement. Ainsi, en deçà d'une certaine charge critique de compression de la genouillère, cette dernière reste rigide axialement. Si une charge de compression supérieure à cette charge critique survient, alors l'équilibre élastique de la genouillère initialement alignée se rompt et la structure flambe. Il convient d'éviter, de préférence, le flambage de la genouillère durant tout le processus de fabrication. S'il est prévu que des forces élevées sollicitent la pièce durant certaines étapes de production (par exemple lors de phases de polissage), alors la rigidité des cols de la genouillère devra être choisie suffisamment élevée pour garantir que la charge critique de flambage est supérieure aux charges de compression maximales attendues sur la genouillère.

### Attaches surnuméraires

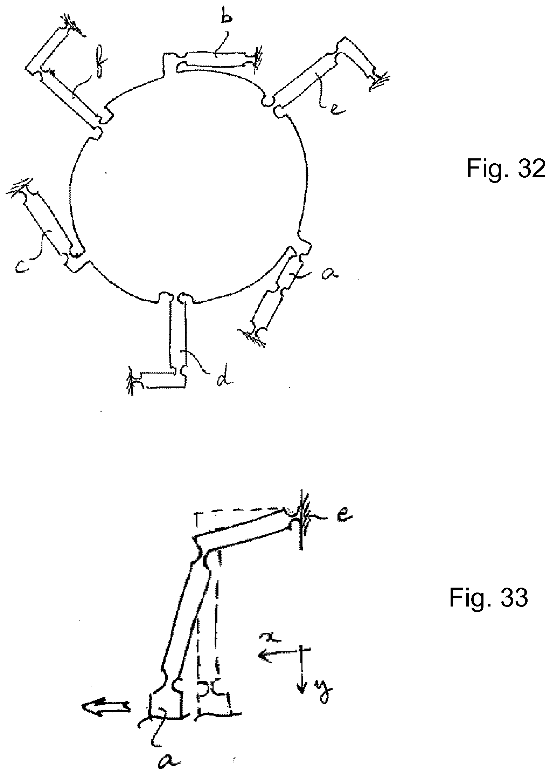

Dans le cas de pièces qui sont fortement sollicitées mécaniquement dans la direction hors-plan durant l'usinage (par exemple durant des étapes de polissage, de perçage ou de fraisage) il peut s'avérer nécessaire d'utiliser plus que trois chaînes de liaison pour attacher la pièce au wafer. La présente invention propose l'utilisation de chaînes de liaison en « L simple ». Ces dernières fournissent une liaison que n'est rigide que dans la direction hors-plan et n'interfère donc par avec les fonctions cinématiques planaires des 3 biellettes de base. Ces chaînes, dites surnuméraires (c'est-à-dire non indispensable à la définition de la position de la pièce par rapport au substrat et conférant de l'hyperstaticité), augmentent la rigidité et la résistance mécanique dans la direction hors-plan. La figure 32 montre par exemple comment 3 « L simples » peuvent être utilisés en plus des 3 biellettes de base (cf. fig. 24). Pour la libération d'un tel système d'attache, il est requis de commencer par casser le verrou (a) puis ensuite les biellettes (b et c). Enfin, la pièce elle-même est déplacée dans le plan jusqu'à rupture des cols des « L simple ». La figure 33 montre comment les « L simples » se déforment lorsque la pièce (a) est déplacée par exemple le long de l'axe x (toute autre direction de déplacement dans le plan est également valable).

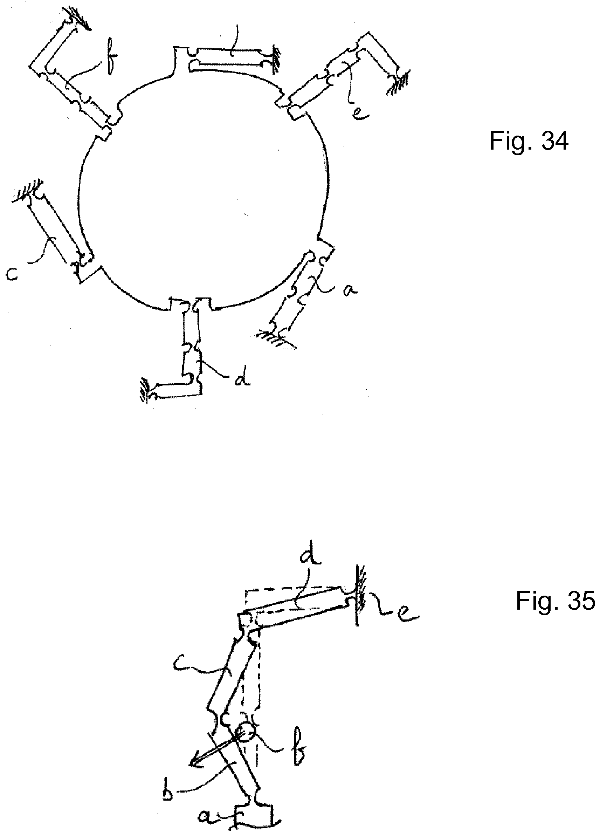

Les « L simples » peuvent être remplacés par les « L à genouillère » (fig. 34). Comme dans le cas des biellettes à genouillère, la singularité d'alignement leur permet de jouer le même rôle cinématique que les « L simples ». Ces « L à genouillère » présentent en outre l'avantage (fig. 35) qu'ils peuvent être rompus individuellement (manuellement ou de manière robotisée) sans requérir de mouvement de la pièce (a) elle-même. Ainsi la séquence stricte décrite requise lorsque des « L simples » sont utilisés (cf. paragraphe ci-dessus) n'a plus besoin d'être respectée. Il est possible de libérer indifféremment les L ou les biellettes en premier. Ceci réduit les risques d'erreur de manipulation.

### Cols noyés

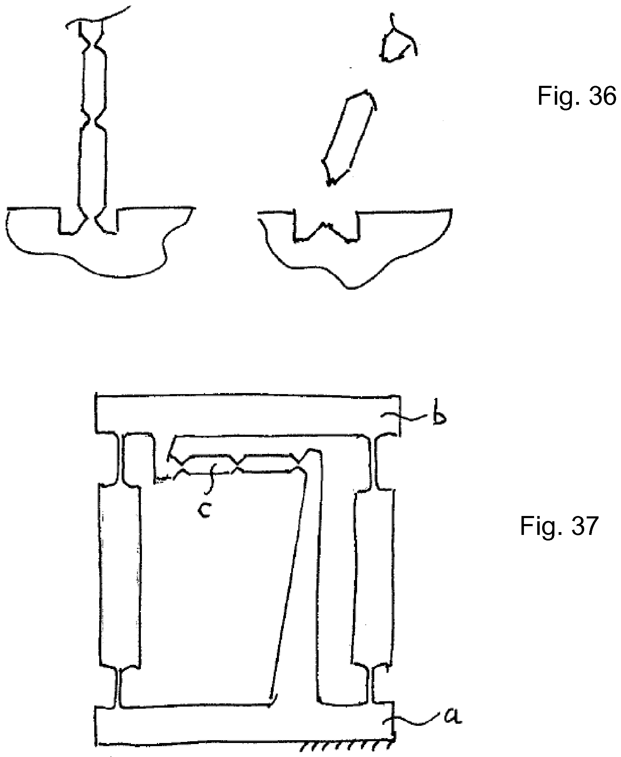

Quel que soit le type de chaîne de liaison utilisé, il y a toujours un col qui est attaché à la pièce elle-même. Après libération, la moitié de ce col reste sur la pièce. La présence de cette petite excroissance peut, dans certains cas, entraver le bon fonctionnement de la pièce. Une solution pour palier partiellement cet inconvénient consiste à noyer ce col, c'est-à-dire à le placer en retrait de la surface de la pièce (fig. 36). Ainsi après libération il n'y a pas d'excroissance qui dépasse de la surface.

### Utilisation de biellettes à genouillère pour le blocage de guidages flexibles

Parfois, la pièce usinée comporte, de manière monolithique, une portion destinée à être articulée sur un bâti au moyen d'un guidage, par exemple un guidage flexible, et le bâti. Les attaches telles que proposées dans la présente invention, notamment les biellettes à genouillère peuvent être utilisées également pour bloquer le mouvement de la portion articulée en référence au bâti, typiquement pour la fabrication ou pour le montage. Ainsi, on a au moins une liaison sacrificielle entre la portion articulée et la bâti en la forme d'un verrou de libération susceptible d'occuper deux états : un état singulier qui permet de bloquer au moins un degré de liberté du guidage et un deuxième état qui permet de mettre ladite portion en mouvement selon un degré de liberté du guidage bloqué dans l'état singulier, jusqu'à la rupture de la liaison sacrificielle, le mouvement induit par le déverrouillage correspondant à l'un des degrés de liberté du guidage. Ce dernier tolère ainsi ce mouvement, sans que n'apparaissent d'efforts ou de contraintes importantes dans la pièce, c'est-à-dire susceptibles de l'endommager.

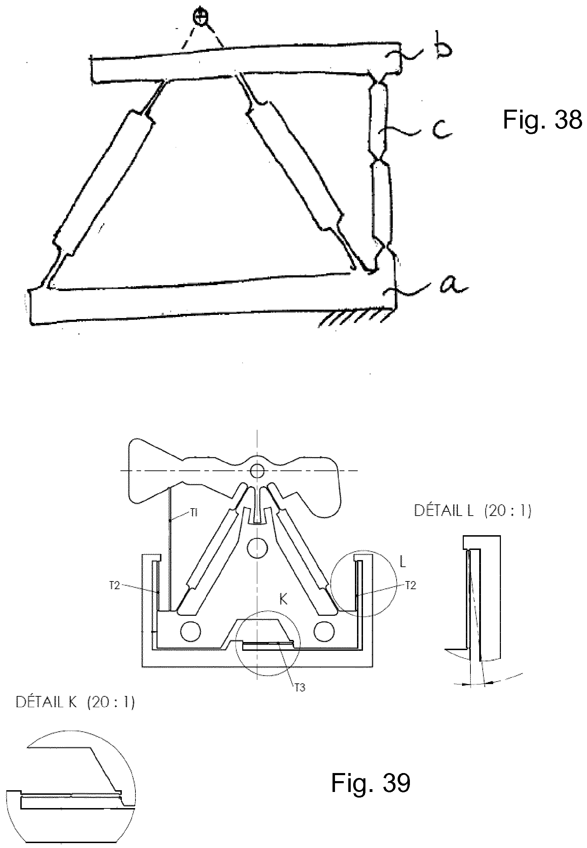

La figure 37 montre l'exemple typique d'une table à 4 cols flexibles. Ce type de pièce doit être immobilisé durant les phases d'usinage pour éviter tout mouvement intempestif de la plateforme mobile (b). Ceci peut être avantageusement réalisé au moyen d'une biellette à genouillère (c) liant la plateforme à la base (a). Cette base (a) sera elle-même attachée au wafer au moyen de trois biellettes (non représentées sur cette figure). La figure 38 montre l'exemple typique d'un pivot à centre de compliance déporté (RCC) dont la rotation est verrouillée par une biellette à genouillère.

### Exemples

La figure 39 montre le plan d'un pivot RCC à l'échelle (ce qui ne permet pas de clairement distinguer les cols), dont la rotation est bloquée par une biellette à genouillère T1 et dont la base est attachée au wafer par deux biellettes simples T2 et une deuxième biellette à genouillère T3. Ces pièces ont été dimensionnées pour être usinées dans un wafer (typiquement de 350 microns d'épaisseur) de silicium monocristallin par gravure profonde (DRIE). La première biellette à genouillère T1 permet de maintenir, lors du montage de la pièce, la bascule pivotée par le pivot RCC. Une fois la pièce assemblée dans son mécanisme, la biellette à genouillère T1 peut être rompue selon son degré de liberté naturel pour libérer le pivot RCC.

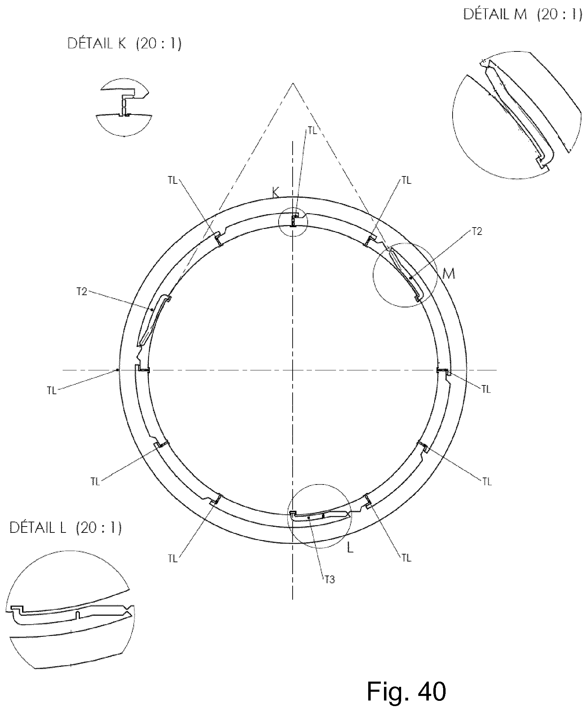

La figure 40 montre un disque qui doit passer par des étapes de polissage durant son processus de fabrication. Ce disque est attaché au wafer (500 microns d'épaisseur) par deux biellettes simples T2, une biellette à genouillère T3 et neuf « L à genouillère » TL. Tous les cols sont noyés en retrait de la surface, à la périphérie du disque. La libération du disque passe, d'abord, par la rupture des neuf L à genouillère, selon leur degré de liberté naturelle pour réduire les contraintes subies par la pièce. Puis, on se retrouve dans le cas de la figure 24, on libère la biellette à genouillère et enfin les deux biellettes simples T2.

Finalement, que ce soit pour la liaison d'une pièce à son substrat ou pour le maintien d'une portion articulée par rapport à son bâti, on utilise pour immobiliser temporairement une pièce micromécanique, une attache sacrificielle articulée au moins à son extrémité située du côté de la pièce micromécanique. L'attache sacrificielle est agencée de manière à immobiliser la pièce micromécanique et elle peut être rompue par un actionnement autour de l'articulation.

L'attache sacrificielle articulée peut être un verrou de libération susceptible d'occuper deux états : un état singulier qui correspond à un état cinématique limité de la pièce, et un deuxième état dans lequel la pièce présente un moins un degré de liberté supplémentaire par rapport à l'état singulier, le déplacement de la pièce selon ce degré de liberté supplémentaire pouvant entraîner une rupture de l'attache sacrificielle articulée. Dans le cas où la pièce est formée d'un bâti et d'une portion articulée sur le bâti, l'attache sacrificielle peut également être un col 2D ou un col 3D localisé précisément sur l'un des axes de rotation de la portion articulée. Le déplacement de la pièce selon ce degré de liberté peut entraîner la rupture de l'attache sacrificielle. Par exemple, sur la figue 41, on a une portion articulée 6 en référence à un bâti 2 par deux biellettes 5. Le bâti est relié au substrat 1 par deux biellettes sacrificielles 4 et par une biellette à genouillère 3 sacrificielle. La portion articulée 6 est également reliée au substrat par un col 2D sacrificiel 7 afin d'immobiliser la portion articulée au cours de son montage. Le col 2D peut être rompu en imprimant un mouvement de rotation autour de l'axe du col, selon la flèche 8.

La présente invention trouve une application particulièrement avantageuse pour la réalisation de pièces micromécaniques par gravure profonde, à base de silicium à partir d'un wafer mais elle peut également être mise en oeuvre pour des pièces réalisées à base de verre ou d'alliages métalliques, à partir d'un substrat. Selon le matériau considéré, on peut usiner la pièce par usinage laser, usinage jet d'eau, usinage par électroérosion, usinage LIGA, usinage chimique du verre, etc. Par rapport à des attaches simples, formées de simples poutres, les attaches articulées selon l'invention permettent de fonctionnaliser la liaison entre la pièce et son substrat pour lui conférer une rigidité ou une liberté dans les degrés de liberté voulus en fonction d'une application donnée et permettent, en outre, de maitriser la libération d'énergie dans le substrat et la pièce lors de la rupture des attaches. On constate une forte diminution du nombre de pièces endommagées ou brisées lors de leur fabrication ou lors de leur libération de leur substrat.

On notera encore que les différents exemples proposés ci-dessus peuvent être orientés de manière indifférente par rapport au substrat, y compris par rotation des attaches sur elles-mêmes, autour de leur axe, en référence au substrat.

## Revendications

1. Méthode de fabrication d'une pièce (d) micromécanique à partir d'un substrat dans laquelle la pièce est fabriquée en ménageant une pluralité d'attaches (a, b, c) entre la pièce et le substrat, lesdites attaches étant sacrificielles et la méthode comprenant une étape de rupture des attaches sacrificielles, lesdites attaches comprenant au moins une articulation (2, 4, 7) à l'extrémité de chaque attache située du côté de la pièce, **caractérisée en ce que** l'une des attaches (a) comporte au moins un verrou de libération susceptible d'occuper deux états : un état singulier qui correspond à un état cinématique limité de la pièce, et un deuxième état dans lequel la pièce présente un moins un degré de liberté supplémentaire par rapport à l'état singulier, le déplacement de la pièce selon ce degré de liberté supplémentaire pouvant entraîner une rupture de l'attache sacrificielle (a) comportant ledit verrou de libération.

2. Méthode de fabrication selon la revendication 1, **caractérisée en ce que** lesdites attaches (a, b, c) comprennent une deuxième articulation (3, 5, 6) à leur extrémité située du côté du substrat.

3. Méthode selon l'une des revendications 1 et 2, **caractérisée en ce que** lesdites attaches (a, b, c) sont choisies parmi une biellette simple, une biellette à genouillère, un L simple, un L à genouillère, une biellette de l'espace, une biellette de l'espace à genouillère un barreau de torsion, un col 2D et un col 3D, une lame 2D à trois cols et une lame 3D à trois cols.

4. Méthode selon l'une des revendications précédentes, **caractérisée en ce que** ledit verrou de libération est doté d'au moins une zone de fragilité destinée à favoriser sa rupture.

5. Méthode selon la revendication 4, **caractérisée en ce que** la pluralité d'attaches (a, b, c) forme une liaison isostatique à zéro degré de liberté dans le plan entre la pièce (d) et le substrat, ladite liaison isostatique comporte au moins trois biellettes flexibles aux axes non-concourants, dont une au moins est une biellette à genouillère flexible servant de verrou de libération.

6. Méthode selon la revendication 5, **caractérisée en ce que** les deux autres biellettes sont des biellettes simples.

7. Méthode selon la revendication 6, **caractérisée en ce que** l'axe (a) de la biellette à genouillère est perpendiculaire à une ligne (f) connectant le point de concours (A) des axes des deux biellettes simples au premier col (e) de la biellette à genouillère.

8. Méthode selon la revendication 6, **caractérisée en ce que** les deux biellettes simples sont parallèles et **en ce que** la biellette à genouillère est perpendiculaire aux deux biellettes simples.

9. Méthode selon l'une des revendications précédentes, **caractérisée en ce que** lesdites attaches sont reliées à la pièce par un col en retrait de la périphérie de la pièce.

10. Méthode selon l'une des revendications précédentes, **caractérisée en ce que** la pièce est en outre reliée au substrat par des attaches surnuméraires rigides uniquement dans une direction hors-plan.

11. Méthode selon l'une des revendications précédentes, **caractérisée en ce que** la pièce est réalisée à base de silicium, d'alliages métalliques ou de verre.

12. Ensemble formé par une pièce (d) usinée dans un substrat et encore attachée au substrat, **caractérisé en ce que** ladite pièce est reliée à son substrat par une pluralité d'attaches sacrificielles (a, b, c), l'une des attaches (a) comportant au moins un verrou de libération susceptible d'occuper deux états : un état singulier qui correspond à un état cinématique limité de la pièce, et un deuxième état dans lequel la pièce présente au moins un degré de liberté supplémentaire par rapport à l'état singulier, le déplacement de la pièce selon ce degré de liberté supplémentaire pouvant entraîner une rupture de l'attache sacrificielle (a) comportant au moins un verrou de libération, et **en ce que** lesdites attaches comprennent au moins une articulation (2, 4, 7) à leur extrémité située du côté de la pièce.

13. Pièce (d) micromécanique , comprenant:
- un bâti (b),
- une portion (a) articulée en référence au bâti,
- au moins un guidage entre la portion articulée et le bâti selon au moins un degré de liberté, et
**caractérisée en ce qu'**elle comprend au moins une attache sacrificielle (c) entre la portion articulée et le bâti en la forme d'un verrou de libération susceptible d'occuper deux états, un état singulier qui permet de bloquer au moins un degré de liberté du guidage et un deuxième état qui permet de mettre ladite portion en mouvement selon ledit degré de liberté du guidage bloqué dans l'état singulier, jusqu'à la rupture de l'attache sacrificielle (c), le mouvement induit par le déverrouillage correspondant à l'un des degrés de liberté du guidage.

14. Utilisation pour une immobilisation temporaire d'une pièce micromécanique (d), d'une attache sacrificielle (a) articulée au moins à son extrémité située du côté de la pièce micromécanique, l'attache sacrificielle articulée étant agencée de manière à immobiliser la pièce micromécanique et pouvant être rompue par un actionnement autour de l'articulation dans laquelle l'attache sacrificielle est un verrou de libération susceptible d'occuper deux états : un état singulier qui correspond à un état cinématique limité de la pièce, et un deuxième état dans lequel la pièce présente un moins un degré de liberté supplémentaire par rapport à l'état singulier, le déplacement de la pièce selon ce degré de liberté supplémentaire pouvant entraîner une rupture de l'attache sacrificielle articulée.

## Patentansprüche

1. Verfahren zur Herstellung eines mikromechanischen Bauteils (d) aus einem Substrat, aus welchem das Bauteil hergestellt ist, durch Ausbildung einer Vielzahl von Verbindern (a, b, c) zwischen dem Bauteil und dem Substrat, wobei die Verbinder opfernd sind und das Verfahren einen Bruchschritt der Opferverbinder umfasst, wobei die Verbinder mindestens ein Gelenk (2, 4, 7) am Ende jedes Verbinders umfassen, das sich an der Seite des Bauteils befindet, **dadurch gekennzeichnet, dass** einer der Verbinder (a) mindestens einen Freisetzungsriegel aufweist, der imstande ist, zwei Zustände einzunehmen: einen singulären Zustand, der einem limitierten kinematischen Zustand des Teils entspricht, und einen zweiten Zustand, in welchem das Teil mindestens einen in Bezug zum singulären Zustand zusätzlichen Freiheitsgrad aufweist, wobei die Verlagerung des Teils gemäß diesem zusätzlichen Freiheitsgrad zu einem Bruch des Opferverbinders (a) führen kann, der den Freisetzungsriegel aufweist.

2. Herstellungsverfahren nach Anspruch 1, **dadurch gekennzeichnet, dass** die Verbinder (a, b, c) ein zweites Gelenk (3, 5, 6) an ihrem Ende umfassen, das sich auf der Seite des Substrats befindet.

3. Verfahren nach einem der Ansprüche 1 und 2, **dadurch gekennzeichnet, dass** die Verbinder (a, b, c) aus einer einfachen Stange, einer Stange mit Knie, einem einfachen L, einem L mit Knie, einer Raumstange, einer Raumstange mit Knie, einem Drehstab, einem 2D-Hals und einem 3D-Hals, einer 2D-Zunge mit drei Hälsen und einer 3D-Zunge mit drei Hälsen ausgewählt sind.

4. Verfahren nach einem der vorangehenden Ansprüche, **dadurch gekennzeichnet, dass** der Freisetzungsriegel mit mindestens einer Empfindlichkeitszone ausgestattet ist, die bestimmt ist, seinen Bruch zu fördern.

5. Verfahren nach Anspruch 4, **dadurch gekennzeichnet, dass** die Vielzahl von Verbindern (a, b, c) eine isostatische Verbindung mit null Freiheitsgrad in der Ebene zwischen dem Bauteil (d) und dem Substrat bildet, wobei die isostatische Verbindung mindestens drei flexible Stangen mit nicht zusammenwirkenden Achsen aufweist, von denen mindestens eine eine Stange mit flexiblen Knie ist, die als Freisetzungsriegel dient.

6. Verfahren nach Anspruch 5, **dadurch gekennzeichnet, dass** die zwei anderen Stangen einfache Stangen sind.

7. Verfahren nach Anspruch 6, **dadurch gekennzeichnet, dass** die Achse (a) der Stange mit Knie senkrecht zu einer Linie (f) ist, die den Kreuzungspunkt (A) der Achsen der zwei einfachen Stangen mit dem ersten Hals (e) der Stange mit Knie koppelt.

8. Verfahren nach Anspruch 6, **dadurch gekennzeichnet, dass** die zwei einfachen Stangen parallel sind und dass die Stange mit Knie senkrecht zu den zwei einfachen Stangen ist.

9. Verfahren nach einem der vorangehenden Ansprüche, **dadurch gekennzeichnet, dass** die Verbinder mit dem Bauteil mittels eines von der Peripherie des Bauteils zurückgezogenen Halses verbunden sind.

10. Verfahren nach einem der vorangehenden Ansprüche, **dadurch gekennzeichnet, dass** das Bauteil mit dem Substrat ferner mittels starrer überzähliger Verbinder nur in einer Off-plan-Richtung verbunden ist.

11. Verfahren nach einem der vorangehenden Ansprüche, **dadurch gekennzeichnet, dass** das Bauteil auf der Basis von Silizium, Metalllegierungen oder Glas hergestellt ist.

12. Einheit, gebildet von einem in einem Substrat ausgearbeiteten und noch mit dem Substrat verbundenen Bauteil (d), **dadurch gekennzeichnet, dass** der Bauteil mit seinem Substrat mittels einer Vielzahl von Opferverbindern (a, b, c) verbunden ist, wobei einer der Verbinder (a) mindestens einen Freisetzungsriegel aufweist, der imstande ist, zwei Zustände einzunehmen: einen singulären Zustand, der einem limitierten kinematischen Zustand des Teils entspricht, und einen zweiten Zustand, in welchem das Teil mindestens einen in Bezug zum singulären Zustand zusätzlichen Freiheitsgrad aufweist, wobei die Verlagerung des Teils gemäß diesem zusätzlichen Freiheitsgrad zu einem Bruch des Opferverbinders (a) führen kann, der mindestens den Freisetzungsriegel aufweist, und dass die Verbinder mindestens ein Gelenk (2, 4, 7) an ihrem Ende umfassen, das sich auf der Seite des Bauteils befindet.

13. Mikromechanisches Bauteil (d), umfassend:
- ein Grundgestell (b),
- einen in Bezug zum Grundgestell angelenkten Abschnitt (a),
- mindestens eine Führung zwischen dem angelenkten Abschnitt und dem Grundgestell gemäß mindestens einem Freiheitsgrad, und
**dadurch gekennzeichnet, dass** es mindestens einen Opferverbinder (c) zwischen dem angelenkten Abschnitt und dem Grundgestell in der Form eines Freisetzungsriegels umfasst, der imstande ist, zwei Zustände einzunehmen, einen singulären Zustand, der erlaubt, mindestens einen Freiheitsgrad der Führung zu blockieren, und einen zweiten Zustand, der erlaubt, den Abschnitt gemäß dem Freiheitsgrad der im singulären Zustand blockierten Führung bis zum Bruch des Opferverbinders (c) zu bewegen, wobei die von der Entriegelung induzierte Bewegung einem der Freiheitsgrade der Führung entspricht.

14. Verwendung für eine temporäre Blockade eines mikromechanischen Bauteils (d) eines Opferverbinders (a), der an mindestens seinem Ende, das sich auf der Seite des mikromechanischen Bauteils befindet, angelenkt ist, wobei der angelenkte Opferverbinder derart ausgebildet ist, dass das mikromechanische Bauteil blockiert ist und mittels einer Betätigung um das Gelenk, bei dem der Opferverbinder ein Freisetzungsriegel ist, der zwei Zustände einnehmen kann: einen singulären Zustand, der einem limitierten kinematischen Zustand des Teils entspricht, und einen zweiten Zustand, in welchem das Teil mindestens einen in Bezug zum singulären Zustand zusätzlichen Freiheitsgrad aufweist, zerbrechbar ist, wobei die Verlagerung des Teils gemäß diesem zusätzlichen Freiheitsgrad zu einem Bruch des angelenkte Opferverbinders (a) führen kann.

## Claims

1. A method for manufacturing a micromechanical part (d) from a substrate in which the part is manufactured by forming a plurality of fasteners (a, b, c) between the part and the substrate, said fasteners being sacrificial and the method comprising a step for breaking the sacrificial fasteners, said fasteners comprising at least one hinge (2, 4, 7) at the end of each fastener situated on the side of the part, **characterized in that** one of the fasteners (a) includes at least one unlocking mechanism capable of occupying two states: a singular state that corresponds to a limited kinematic state of the part, and a second state in which the part has at least one additional degree of freedom relative to the singular state, the movement of the part according to that additional degree of freedom being able to cause the sacrificial fastener (a) including said unlocking mechanism to break.

2. The manufacturing method of claim 1, **characterized in that** said fasteners comprise a second hinge (3, 5, 6) at their end situated on the side of the substrate.

3. The method according to any one of claims 1 and 2, **characterized in that** said fasteners (a, b, c) are chosen from among a simple connecting rod, a connecting rod with an intermediate hinge, a L shaped simple connecting rod, a L shaped simple rod with an intermediate hinge, a spatial rod, a spatial rod with an intermediate hinge, a torsion bar, a 2D neck and 3D neck, a 2D blade with three necks and a 3D blade with three necks.

4. The method according to any preceding claim, **characterized in that** said unlocking mechanism is provided with at least one fragile zone designed to favor breaking thereof.

5. The method according to claim 4, **characterized in that** the plurality of fasteners (a, b, c) forms an isostatic connection with zero degrees of freedom in the plane between the part (d) and the substrate, said isostatic connection includes at least three flexible links with non-concurrent axes, at least one of which is a flexible connecting rod with an intermediate hinge serving as unlocking mechanism.

6. The method according to claim 5, **characterized in that** the other two links are simple connecting rods.

7. The method according to claim 6, **characterized in that** the axis (a) of the connecting rod with an intermediate hinge is perpendicular to a line (f) connecting the cooperation point (A) of the axes of the two simple connecting rods to the first neck (e) of the connecting rod with an intermediate hinge.

8. The method according to claim 6, **characterized in that** the two simple connecting rods are parallel and **in that** the connecting rod with an intermediate hinge is perpendicular to the two simple connecting rods.

9. The method according to one of the preceding claims, **characterized in that** said fasteners are connected to the part by a neck withdrawn from the periphery of said part.

10. The method according to one of the preceding claims, **characterized in that** the part is further connected to the substrate by rigid supernumerary fasteners only in an out-of-plane direction.

11. The method according to one of the preceding claims, **characterized in that** the parts is made with from silicon, metal alloys or glass.

12. An assembly formed by a part (d) machined in a substrate and still fastened to the substrate, **characterized in that** said part is connected to its substrate by a plurality of sacrificial fasteners (a, b, c), one of the fasteners (a) including at least one unlocking mechanism capable of occupying two states: a singular state that corresponds to a limited kinematic state of the part, and a second state in which the part has at least one additional degree of freedom relative to the singular state, the movement of the part according to that additional degree of freedom being able to cause the sacrificial fastener (a) including said unlocking mechanism to break, and **in that** said fasteners comprise at least one hinge (2, 4, 7) at their end situated on the side of the part.

13. A part that may be obtained using the method according to one of claims 1 to 28, said part comprising:
- a frame (b),
- a portion (a) hinged in reference to the frame,
- at least one guide between the hinged portion and the frame in at least one degree of freedom, and
**characterized in that** it comprises at least one sacrificial fastener (c) between the hinged portion and the frame in the form of an unlocking mechanism capable of occupying two states, a singular state that makes it possible to block at least one degree of freedom of the guide, and a second state that makes it possible to set said portion in motion according to said degree of freedom of the guide blocked in the singular state, until the sacrificial fastener (c) breaks, the movement caused by the unlocking corresponding to one of the degrees of freedom of the guide.

14. A use for temporary immobilization of a micromechanical part (d), of a sacrificial fastener (a) hinged at least at its end situated on the side of the micromechanical part, the hinged sacrificial fastener being arranged so as to immobilize the micromechanical part and being able to be broken by actuation around the hinge, wherein the sacrificial fastener is an unlocking mechanism capable of occupying two states: a singular state that corresponds to a limited kinematic state of the part, and a second state in which the part has at least one additional degree of freedom relative to the singular state, the movement of the part according to that additional degree of freedom being able to cause the sacrificial fastener including said unlocking mechanism to break.
